# EUROPEAN PATENT APPLICATION

(11) **EP 4 651 693 A1**
(43) Date of publication of application: **19.11.2025**
(21) Application number: 24867181.0
(22) Date of filing: 14.08.2024
(51) Int. Cl.: H10K 59/40, H10K 59/131, G06F 3/041

(54) **DISPLAY PANEL AND DISPLAY APPARATUS**

(30) Priority: 22.09.2023 CN 202311236720
(71) Applicant: BOE Technology Group Co., Ltd., Beijing 100015 (CN); Chengdu BOE Optoelectronics Technology Co., Ltd., Chengdu, Sichuan 611731 (CN); Beijing BOE Technology Development Co., Ltd., Beijing 100176 (CN)
(72) Inventor: LI, Haibo, Beijing 100176 (CN); XIN, Yanxia, Beijing 100176 (CN); HE, Wei, Beijing 100176 (CN); LI, Xueping, Beijing 100176 (CN); WU, Yihao, Beijing 100176 (CN); WANG, Xiaoyun, Beijing 100176 (CN); ZHAO, Yu, Beijing 100176 (CN); ZHOU, Yuzhu, Beijing 100176 (CN); ZHANG, Feng, Beijing 100176 (CN); HUI, Yan, Beijing 100176 (CN); HUANG, Yongming, Beijing 100176 (CN)
(74) Representative: Cohausz & Florack
(86) International application number: PCT/CN2024/112123
(87) International publication number: WO 2025/060764

(57) **Abstract**

The present invention provides a display panel and a display apparatus. The display panel comprises: a substrate, the substrate comprising a display area and a peripheral area, and the peripheral area comprising a binding area and a transition area located between the binding area and the display area; a source/drain metal layer, which comprises a binding part at least located in the binding area and a connecting part located in the transition area; a planarization layer, which is provided on the substrate and is provided with a first opening located in the binding area and a first via located in the transition area, respectively; a first organic insulation layer, which is provided on the side of the planarization layer away from the substrate and is provided with a third via corresponding to the first via; a first metal structure, which is located in the peripheral area and is at least provided on the side of the first organic insulation layer away from the substrate, the orthographic projection of the first metal structure on the substrate at least covering the first opening and the first via; and a second metal structure, which is provided on the side of the first metal structure away from the substrate and is in contact with the first metal structure. According to the display panel provided by the present invention, the problem of short circuiting caused by metal residue during process manufacturing can be solved, and product yield is increased.

## Description

### Cross-references to Related Applications

The present disclosure claims priority to a Chinese patent application No. 202311236720.3, filed with China National Intellectual Property Administration on September 22, 2023, and entitled "DISPLAY PANEL AND DISPLAY DEVICE", the entire contents of which are incorporated herein by reference.

### Technical Field

The present disclosure relates to the field of display technology, in particular to a display panel and a display device.

### Background

**In** recent years, the technology of fabricating a touch structure directly on an encapsulation layer of an organic light-emitting diode (OLED) display panel (Flexible Multi-Layer On Cell (FMLOC)) has been widely used for its ability to prepare the lighter and thinner display device. With the gradual increase in demand for flexible screens, an organic film layer is sometimes used as a touch insulating layer in order to meet market demand. However, this design also results in the touch structure being susceptible to short-circuiting defects in the peripheral region of the display panel, leading to a decrease in the yield of the display panel.

### Summary

The present disclosure is aimed to provide a display panel and a display device to solve a problem in the related art.

In order to achieve the above aim, the present disclosure provides the following technical solution.

As an aspect of the present disclosure, the present disclosure provides a display panel, including: a substrate, including a display region and a peripheral region, where the peripheral region includes a bonding region spaced apart from the display region, and a transition region between the bonding region and the display region; a source-drain metal layer, including a bonding portion at least partially located in the bonding region and a connection portion located in the transition region, where the bonding portion is electrically connected with the connection portion; a planarization layer, provided on the substrate and provided with a first opening in the bonding region and a first via hole in the transition region, where the first opening exposes the bonding portion and the first via hole exposes the connection portion; a first organic insulating layer, located in the display region and the peripheral region, provided on a side of the planarization layer facing away from the substrate, and provided with a third via hole corresponding to the first via hole; a first metal structure, located in the peripheral region and at least partially provided on a side of the first organic insulating layer facing away from the substrate; where an orthographic projection of the first metal structure on the substrate at least covers an orthographic projection of the first opening and the first via hole on the substrate, and the first metal structure is electrically connected with the connection portion through the first via hole and the third via hole; and a second metal structure, located in the peripheral region and provided on a side of the first metal structure facing away from the substrate; where the second metal structure is in direct contact with the first metal structure.

Exemplarily, the transition region includes a first transition region, a second transition region, and a bending region between the first transition region and the second transition region; where the first transition region is between the bending region and the display region, and the second transition region is between the bending region and the bonding region; the first via hole and the third via hole are in the second transition region; and the connection portion is in the first transition region, the bending region, and the second transition region, and is a continuous structure.

Exemplarily, the display panel further includes: a second organic insulating layer, provided on the side of the first organic insulating layer facing away from the substrate and provided with a sixth via hole in the display region; a first touch metal layer, provided in the display region and at least partially extending into the transition region, where the first touch metal layer is on a side of the second organic insulating layer facing away from the substrate; and a second touch metal layer, located on a side of the second organic insulating layer facing the substrate; where the first touch metal layer is electrically connected with the second touch metal layer through the sixth via hole.

Exemplarily, the first touch metal layer includes a first touch electrode in the display region and a first touch wiring in the transition region; the planarization layer further includes a second via hole in the first transition region, where the second via hole exposes the connection portion; and the first organic insulating layer is further provided with a fourth via hole corresponding to the second via hole, and the first touch wiring is electrically connected with the connection portion through the second via hole and the fourth via hole.

Exemplarily, the second organic insulating layer is provided with a second boundary in the transition region; where an orthographic projection of the second boundary on the substrate is on a side of an orthographic projection of the first touch metal layer on the substrate facing away from the display region.

Exemplarily, the orthographic projection of the second boundary on the substrate is in the bending region.

Exemplarily, a spacing distance from the second boundary to the display region is greater than or equal to 1600 µm.

Exemplarily, the first organic insulating layer is provided with a first boundary; where the first boundary is a boundary of the first organic insulating layer facing away from the display region, and a spacing distance between an orthographic projection of the first boundary on the substrate and an orthographic projection of the first opening on the substrate is greater than or equal to 50 µm.

Exemplarily, the first boundary is on a side of the bonding region facing away from the display region, and the orthographic projection of the first boundary on the substrate is on a side of the orthographic projection of the first metal structure on the substrate facing away from the display region; and the first organic insulating layer is provided with a fifth via hole corresponding to the first opening, and the first metal structure is electrically connected with the bonding portion through the first opening and the fifth via hole.

Exemplarily, the source-drain metal layer includes a first source-drain metal layer and a second source-drain metal layer, and the bonding portion includes a first bonding portion and a second bonding portion, where the first source-drain metal layer is provided with the first bonding portion, and the second source-drain metal layer is provided with the second bonding portion and the connection portion; and a passivation layer, at least partially located in the bonding region, where the first source-drain metal layer, the passivation layer and the second source-drain metal layer are sequentially arranged in a direction facing away from the substrate; where the passivation layer is provided with a second opening in the bonding region, and the first bonding portion is electrically connected with the second bonding portion through the second opening.

Exemplarily, the first metal structure is provided in the same one layer as the first touch metal layer and is made of the same material as the first touch metal layer, and the second metal structure is provided in the same one layer as the second touch metal layer and is made of the same material as the second touch metal layer.

Exemplarily, the display panel further includes a pixel defining layer, provided on a substrate, located in the display region, and provided with a sixth opening; a light-emitting layer, provided within the sixth opening; and an encapsulation layer, at least partially located in the display region, where an orthographic projection of the encapsulation layer on the substrate covers an orthographic projection of the pixel defining layer and the light-emitting layer on the substrate; where the first organic insulating layer is provided at least partially on a side of the encapsulation layer facing away from the substrate.

As another aspect of the present disclosure, the present disclosure provides a display panel including: a substrate, including a display region and a peripheral region surrounding the display region, where the peripheral region includes a bonding region spaced apart from the display region, and a transition region between the bonding region and the display region; a source-drain metal layer, including a bonding portion at least partially located in the bonding region and a connection portion located in the transition region, where the bonding portion is electrically connected with the connection portion; a planarization layer, provided on the substrate and provided with a first opening in the bonding region and a first via hole in the transition region, where the first opening exposes the bonding portion and the first via hole exposes the connection portion; a first organic insulating layer, located in the display region and the peripheral region, provided on a side of the planarization layer facing away from the substrate, and provided with a third via hole corresponding to the first via hole; where the first organic insulating layer is provided with a first boundary, and the first boundary is a boundary of the first organic insulating layer facing away from the display region; a first metal structure, located in the peripheral region and at least partially provided on a side of the first organic insulating layer facing away from the substrate; where an orthographic projection of the first metal structure on the substrate at least covers an orthographic projection of the first opening and the first via hole on the substrate, and the first metal structure is electrically connected with the connection portion through the first via hole and the third via hole; and a second metal structure, located in the peripheral region and provided on a side of the first metal structure facing away from the substrate; where an orthographic projection of the first boundary on the substrate does not overlap with either the orthographic projection of the first metal structure on the substrate or an orthographic projection of the second metal structure on the substrate.

Exemplarily, the display panel further includes: a second organic insulating layer, including a first organic insulating sub-portion located in the display region and at least partially extending into the transition region, where the first organic insulating sub-portion is provided on the side of the first organic insulating layer facing away from the substrate and provided with a sixth via hole in the display region; a first touch metal layer, provided in the display region and at least partially extending into the transition region, where the first touch metal layer is on a side of the second organic insulating layer facing away from the substrate; and a second touch metal layer, located on a side of the second organic insulating layer facing the substrate; where the first touch metal layer is electrically connected with the second touch metal layer through the sixth via hole.

Exemplarily, the transition region includes a first transition region, a second transition region, and a bending region between the first transition region and the second transition region; where the first transition region is between the bending region and the display region; the second transition region is between the bending region and the bonding region; the connection portion is in the first transition region, the bending region, and the second transition region, and is a continuous structure.

Exemplarily, the first touch metal layer includes a first touch electrode in the display region and a first touch wiring in the transition region; the planarization layer further includes a second via hole in the first transition region, where the second via hole exposes the connection portion; and the first organic insulating layer is further provided with a fourth via hole corresponding to the second via hole, and the first touch wiring is electrically connected with the connection portion through the second via hole and the fourth via hole.

Exemplarily, the second organic insulating layer is provided with a second organic insulating sub-portion at least partially located in the second transition region, and a fourth opening located between the first organic insulating sub-portion and the second organic insulating sub-portion, where an orthographic projection of the fourth opening on the substrate at least partially overlaps with the bending region.

Exemplarily, the first metal structure is provided in the bonding region and the second transition region, and the first metal structure is provided with a third opening in the second transition region; where the orthographic projection of the first boundary on the substrate is within an orthographic projection of the third opening on the substrate, and a first gap is between the first boundary and the bonding region.

Exemplarily, on a side of the third opening facing the display region, the first metal structure, the second organic insulating sub-portion, and the second metal structure are sequentially stacked in a direction perpendicular to the substrate; and the second organic insulating layer is further provided with a fifth opening in the second transition region, where the first metal structure is electrically connected with the second metal structure through the fifth opening.

Exemplarily, the second organic insulating sub-portion is provided with a third boundary and a fourth boundary, where an orthographic projection of the third boundary on the substrate is on a side of an orthographic projection of the fourth boundary on the substrate facing away from the display region; and the orthographic projection of the third boundary on the substrate and the orthographic projection of the fourth boundary on the substrate are between an orthographic projection of the first gap on the substrate and the orthographic projection of the fourth opening on the substrate, and the orthographic projection of the third boundary on the substrate is on a side of the orthographic projection of the first boundary on the substrate facing the display region.

Exemplarily, the first boundary is on a side of the bonding region facing away from the display region.

Exemplarily, the second organic insulating layer is provided with a second organic insulating sub-portion at least partially located in the second transition region, and a fourth opening between the first organic insulating sub-portion and the second organic insulating sub-portion, where an orthographic projection of the fourth opening on the substrate at least partially overlaps with the bending region; and the second organic insulating sub-portion includes a fifth opening in the second transition region and a seventh via hole in the bonding region, where the first metal structure is electrically connected with the second metal structure through the fifth opening and the seventh via hole.

Exemplarily, the second organic insulating sub-portion is provided with a third boundary and a fourth boundary, where an orthographic projection of the third boundary on the substrate is on a side of an orthographic projection of the fourth boundary on the substrate facing away from the display region, and the third boundary is on a side of the bonding region facing away from the display region.

Exemplarily, the orthographic projection of the third boundary on the substrate is on a side of the orthographic projection of the first boundary on the substrate facing away from the display region.

Exemplarily, the orthographic projection of the fourth boundary on the substrate is in the bending region.

Exemplarily, the first organic insulating sub-portion is provided with a second boundary, where an orthographic projection of the second boundary on the substrate is on a side of the fourth opening facing the display region.

Exemplarily, the orthographic projection of the second boundary on the substrate is in the bending region.

Exemplarily, a spacing distance between the orthographic projection of the first boundary on the substrate and an orthographic projection of the first opening on the substrate is greater than or equal to 50 µm.

Exemplarily, the first metal structure is provided in the same one layer as the first touch metal layer and is made of the same material as the first touch metal layer, and the second metal structure is provided in the same one layer as the second touch metal layer and is made of the same material as the second touch metal layer.

Exemplarily, the source-drain metal layer includes a first source-drain metal layer and a second source-drain metal layer, and the bonding portion includes a first bonding portion and a second bonding portion, where the first source-drain metal layer is provided with the first bonding portion, and the second source-drain metal layer is provided with the second bonding portion and the connection portion; and a passivation layer, at least partially located in the bonding region, where the first source-drain metal layer, the passivation layer and the second source-drain metal layer are sequentially arranged in a direction facing away from the substrate; where the passivation layer is provided with a second opening in the bonding region, and the first bonding portion is electrically connected with the second bonding portion through the second opening.

Exemplarily, the display panel further includes a pixel defining layer, provided on a substrate, located in the display region, and provided with a sixth opening; a light-emitting layer, provided within the sixth opening; and an encapsulation layer, at least partially located in the display region, where an orthographic projection of the encapsulation layer on the substrate covers an orthographic projection of the pixel defining layer and the light-emitting layer on the substrate; where the first organic insulating layer is provided at least partially on a side of the encapsulation layer facing away from the substrate.

The present disclosure also provides a display device including the display panel as described above.

The beneficial effects of the technical solution provided by the present disclosure include at least as below.

The present disclosure provides a display panel including: a substrate, including a display region and a peripheral region, where the peripheral region includes a bonding region spaced apart from the display region, and a transition region between the bonding region and the display region; a source-drain metal layer, including a bonding portion at least partially located in the bonding region and a connection portion located in the transition region, where the bonding portion is electrically connected with the connection portion; a planarization layer, provided on the substrate and provided with a first opening in the bonding region and a first via hole in the transition region, where the first opening exposes the bonding portion and the first via hole exposes the connection portion; a first organic insulating layer, located in the display region and the peripheral region, provided on a side of the planarization layer facing away from the substrate, and provided with a third via hole corresponding to the first via hole; a first metal structure, located in the peripheral region and at least partially provided on a side of the first organic insulating layer facing away from the substrate; where an orthographic projection of the first metal structure on the substrate at least covers an orthographic projection of the first opening and the first via hole on the substrate, and the first metal structure is electrically connected with the connection portion through the first via hole and the third via hole; and a second metal structure, located in the peripheral region and provided on a side of the first metal structure facing away from the substrate; where the second metal structure is in direct contact with the first metal structure. There is no second organic insulating layer between the first metal structure and the second metal structure, and there is also no step formed by the second organic insulating layer, and thus the metal residue can be avoided during fabricating the second metal structure. In this way, since there is no second organic insulating layer for protection above the residue of the first metal structure originally generated at the boundary of the first organic insulating layer, the residue of the first metal structure generated at the boundary of the first organic insulating layer can also be further etched during the patterning of the second metal structure, thus avoiding a short circuit at this position due to the metal residue, and ensuring the product yield.

### Brief Description of Figures

In order to more clearly illustrate the specific embodiments of the present disclosure or the technical solutions in the related art, the specific embodiments of the present disclosure are described in further detail below in conjunction with the accompanying drawings. Obviously, the accompanying drawings in the following description are some of the embodiments of the present disclosure, and for a person of ordinary skill in the art, other accompanying drawings can be obtained based on these drawings without creative labor.
FIG. 1 illustrates a top view of a display panel.
FIG. 2 illustrates a schematic diagram of a cross-section of some structures along a section line I-I' of FIG. 1 in the related art.
FIG. 3 illustrates a schematic diagram of a cross-section of some structures along the section line I-I' of FIG. 1 according to embodiments of the present disclosure.
FIG. 4 illustrates another schematic diagram of a cross-section of some structures along the section line I-I' of FIG. 1 according to embodiments of the present disclosure.
FIG. 5 illustrates another schematic diagram of a cross-section of some structures along the section line I-I' of FIG. 1 according to embodiments of the present disclosure.
FIG. 6 illustrates another schematic diagram of a cross-section of some structures along the section line I-I' of FIG. 1 according to embodiments of the present disclosure.
FIG. 7 illustrates another schematic diagram of a cross-section of some structures along the section line I-I' of FIG. 1 according to embodiments of the present disclosure.
FIG. 8 illustrates a top view of some structures corresponding to a region where a dotted box M is located in FIG. 2.
FIG. 9 illustrates a top view of some structures corresponding to a region where a dotted box M is located in FIG. 3.
FIG. 10 illustrates a top view of some structures corresponding to a region where a dotted box M is located in FIG. 5.
FIG. 11 illustrates a top view of some structures corresponding to a region where a dotted box M is located in FIG. 6.
FIG. 12 illustrates a top view of some structures corresponding to a region where a dotted box M is located in FIG. 7.

### Detailed Description

The present disclosure is described in further detail below in connection with the accompanying drawings and embodiments. It should be understood that the specific embodiments described herein are only for the purpose of explaining the present disclosure and are not a limitation to the invention. It should also be noted that, for ease of description, only portions and not the entire structure related to the present disclosure are shown in the accompanying drawings.

In the description of the present disclosure, unless otherwise expressly provided and limited, the terms "connected", "connecting", "fixed" shall be broadly construed. For example, it may be a fixed connection, a detachable connection, or a one-piece connection; it may be a direct connection, an indirect connection through an intermediate medium, a connection within two elements or an interaction between two elements. For those of ordinary skill in the art, the specific meaning of the above terms in the present disclosure may be understood in specific cases.

In the present disclosure, unless otherwise expressly provided and limited, the first feature "above/on" or "under" the second feature may include the first and second features being in direct contact, or the first and second features being in contact not directly but through another feature between them.

Unless the context requires otherwise, throughout the specification and the claims, the term "include/comprise" is construed to be open, inclusive, i.e., "include/comprise, but not limited to". In the description of the specification, the term "exemplarily" is intended to indicate that a particular feature, structure, material, or characteristic associated with the embodiment or example is included in at least one embodiment or example of the present disclosure. Schematic representations of the above terms may refer to the same embodiment or example. In addition, the particular features, structures, materials, or characteristics described may be included in any one or more embodiments or examples in any appropriate manner.

In the description of this embodiment, the terms "up", "down", "left", "right", and other orientations or positional relationships are based on the orientations or positional relationships shown in the accompanying drawings, and are used only for the purpose of facilitating description and simplifying operation, and are not intended to indicate or imply that the device or element referred to must have a particular orientation, be constructed and operated with a particular orientation, and therefore are not to be construed as a limitation to the present disclosure. In addition, the terms "first", "second" and the like are used only to make a distinction in the description and have no special meaning.

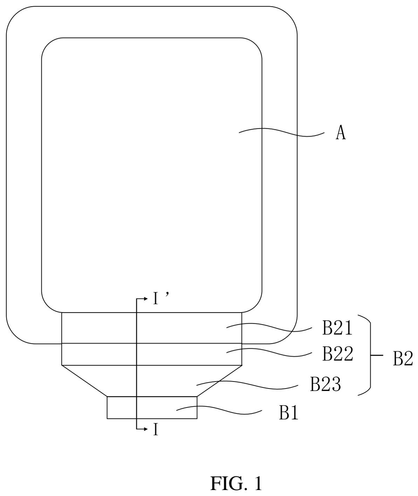

FIG. 1 illustrates a top view of a display panel. As shown in FIG. 1, the display panel may be any device that displays either moving object (e.g., video) or fixed object (e.g., still images) and either text or image. More specifically, it is contemplated that the described embodiments may be implemented in or associated with a plurality of electronic devices. The plurality of electronic devices are, e.g., (but not limited to) mobile telephones, wireless devices, personal data assistants (PDAs), handheld or portable computers, global positioning system (GPS) receivers/navigators, cameras, MP4 video players, camcorders, gaming consoles, watches, clocks, calculators, television monitors, flat panel displays, computer monitors, automotive displays (e.g., odometer displays, etc.), navigators, cockpit controllers and/or monitors, displays for camera views (e.g., displays for rear-view cameras in a vehicle), electronic photographs, electronic billboards or signs, projectors, architectural structures, packaging, and aesthetic structures (e.g., displays for images of a piece of jewelry), and the like. The display panel is illustrated in FIG. 1 as an example of a mobile phone.

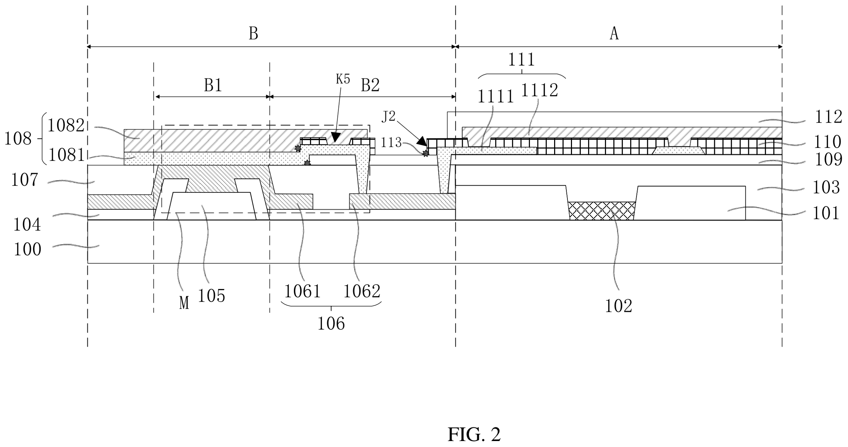

FIG. 2 illustrates a cross-sectional view of some structures along the section line I-I' of FIG. 1 in a related art. As shown in FIG. 2, the display panel includes a substrate 100. The substrate 100 includes a display region A and a peripheral region B. The peripheral region B includes a bonding region B1 spaced apart from the display region A, and a transition region B2 between the bonding region and the display region. A source-drain metal layer includes a bonding portion 1051/1061 at least partially disposed in the bonding region B1, and a connection portion 1062 disposed in the transition region. The bonding portion 1051/1061 is electrically connected with the connection portion 1062. A planarization layer 107 is provided on the substrate 100, and a first organic insulating layer 109 is provided on a side of the planarization layer facing away from the substrate. A first metal structure 1081 is disposed in the peripheral region and is at least partially disposed on a side of the first organic insulating layer 109 facing away from the substrate 100. A second organic insulating layer 110 is at least partially located in the transition region B2, is disposed on a side of the first metal structure 1081 facing away from the substrate, and is provided with a fifth opening K5. A second metal structure 1082 is disposed in the peripheral region, is at least partially disposed on a side of the second organic insulating layer 110 facing away from the substrate and is electrically connected with the first metal structure through the fifth opening K5.

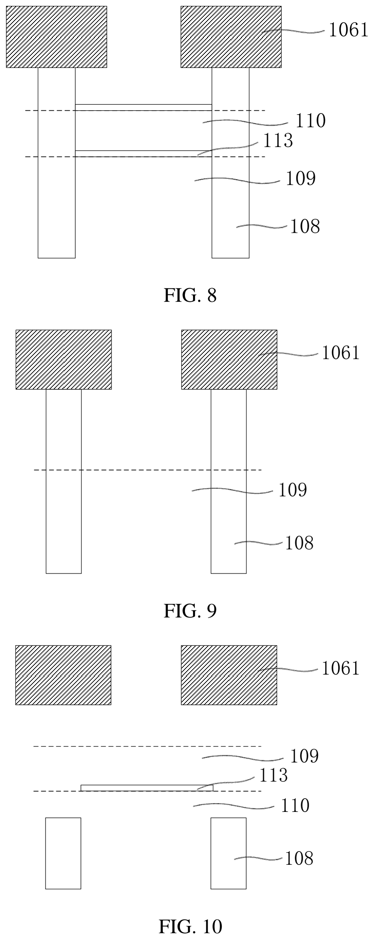

With continued reference to FIG. 2 and FIG. 8, FIG. 8 illustrates a top view of some structures corresponding to a region where the dotted box M is located in FIG. 2. In the related art, in order to satisfy the demand for a flexible screen, an organic material will be selected for the touch insulating layer of the OLED display panel. However, due to the fact that the thickness of the organic material is greater than the thickness of the original inorganic touch insulating layer, a more obvious step may be formed at a boundary between the first organic insulating layer 109 and the second organic insulating layer 110, which will result in a metal residue 113 being easily generated at the step during fabricating the first metal structure 1081 and the second metal structure 1082, which will easily lead to the electrical connection of the metal structures that are adjacent to each other, so as to cause a short circuit, thus affecting the product yield.

In order to solve the problem in the related art, the present disclosure provids a display panel, which may be a liquid crystal display (abbreviated as LCD) panel. The display panel may also be an electroluminescent display panel or a photoluminescent display panel. In the case where the display panel is the electroluminescent display panel, the electroluminescent display panel may be an organic electroluminescent (e.g., Organic Light-Emitting Diode, abbreviated as OLED) display panel or a quantum dot electroluminescent (e.g., Quantum Dot Light-emitting Diode, abbreviated as QLED) display panel. In the case where the display panel is the photoluminescent display panel, the photoluminescent display device may be a quantum dot photoluminescent display panel. In the present disclosure, the display panel is an organic light-emitting diode (OLED) display panel as an example for illustration.

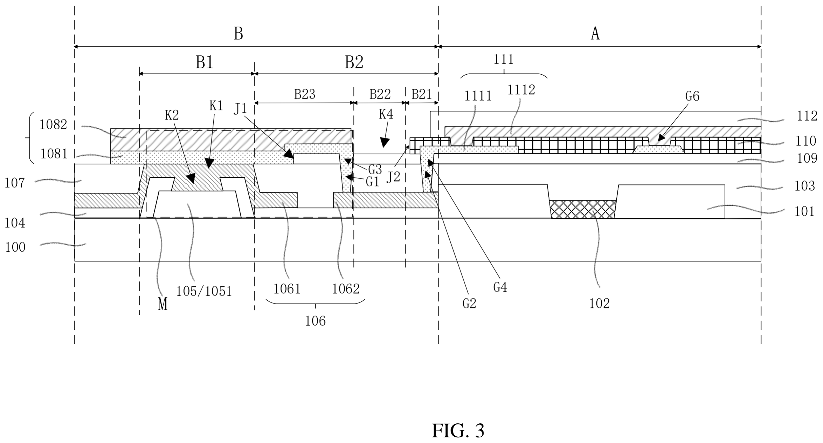

FIGS. 3 to 7 each illustrate a schematic diagram of a cross-section of some structures along the section line I-I' of FIG. 1 according to some embodiments of the present disclosure. As shown in FIGS. 3~7, the display panel includes a substrate 100. The substrate 100 includes a display region A and a peripheral region B surrounding the display region. The peripheral region B includes a bonding region B1 spaced apart from the display region A, and a transition region B2 disposed between the bonding region and the display region. A source-drain metal layer includes a bonding portion 1051/1061 at least partially located in the bonding region B1, and a connection portion 1062 located in the transition region. The bonding portion 1051/1061 is electrically connected with the connection portion 1062. A planarization layer 107 is provided on the substrate 100 and is provided with a first opening K1 in the bonding region and a first via hole G1 in the transition region. The first opening K1 exposes the bonding portion 1051/1061 and the first via hole G1 exposes the connection portion. A first organic insulating layer 109 is located in the display region A and the peripheral region B, is provided on a side of the planarization layer 107 facing away from the substrate, and is provided with a third via hole G3 corresponding to the first via hole G1. The first metal structure 1081 is located in the peripheral region B and is at least partially provided on a side of the first organic insulating layer 109 facing away from the substrate. An orthographic projection of the first metal structure 1081 on the substrate at least covers an orthographic projection of the first opening K1 and the first via hole G1 on the substrate, and the first metal structure 1081 is electrically connected with the connection portion 1062 via the first via hole G1 and the third via hole G3. The second metal structure 1082 is located in the peripheral region B and is provided on a side of the first metal structure facing away from the substrate.

Exemplarily, with continued reference to FIGS. 3 to 7, the transition region includes a first transition region B21, a second transition region B23, and a bending region B22 between the first transition region B21 and the second transition region B23,. The first transition region B21 is between the bending region B22 and the display region A, and the second transition region B23 is between the bending region B22 and the bonding region B1, and the first via hole G1 and the third via hole G3 are in the second transition region B23. The planarization layer 107 further includes a second via hole G2 in the first transition region B21. The second via hole exposes the connection portion 1062, and the connection portion 1062 is in the first transition region B21, the bending region B22, and the second transition region B23 and is a continuous structure. The first organic insulating layer is further provided with a fourth via hole G4 corresponding to the second via hole G2. The display panel further includes a second organic insulating layer 110. The second organic insulating layer 110 is provided on a side of the first organic insulating layer 109 facing away from the substrate 100 and is provided with a sixth via hole G6 in the display region A. The touch metal layer 111 includes a first touch metal layer 1111. The first touch metal layer 1111 is provided in the display region and at least partially extends into the transition region B2, and the first touch metal layer 1111 is on a side of the second organic insulating layer 110 facing away from the substrate 100. Further, the first touch metal layer 1111 includes a first touch electrode in the display region A and a first touch wiring in the transition region B2, and the first touch wiring is electrically connected with the connection portion 1062 through the second via hole G2 and the fourth via hole G4. The touch metal layer 111 further includes a second touch metal layer 1112. The second touch metal layer 1112 is located on a side of the second organic insulating layer 110 facing the substrate 100 and on a side of the first organic insulating layer 109 facing away from the substrate 100, and is electrically connected with the first touch metal layer 1111 through the sixth via hole G6. The connection portion 1062 is located in the transition region, which can avoid conflicts with other wirings in the display region, avoid inter-wire interference, and improve the product yield.

Exemplarily, as shown in FIG. 3, the second metal structure 1082 is located in the peripheral region B and is provided on the side of the first metal structure 1081 facing away from the substrate 100 and is in direct contact with the first metal structure 1081. In the embodiments of the present disclosure, as shown in FIG. 9, FIG. 9 illustrates a top view of some structures corresponding to a region where the dashed box M is located in FIG. 3. By removing the second organic insulating layer in the transition region B2, the first metal structure 1081 and the second metal structure 1082 are in direct contact with each other in the transition region B2. That is, there is no second organic insulating layer between the first metal structure 1081 and the second metal structure 1082, and there is also no step formed by the second organic insulating layer, and thus the metal residue can be avoided during fabricating the second metal structure 1082. In this way, since there is no second organic insulating layer for protection above the residue of the first metal structure 1081 originally generated at the boundary of the first organic insulating layer, the residue of the first metal structure 1081 generated at the boundary of the first organic insulating layer 109 can also be further etched during the patterning of the second metal structure 1082, thus avoiding the short circuit at this position due to the metal residue, and ensuring the product yield.

Exemplarily, the second organic insulating layer 110 is provided with a second boundary J2 in the transition region B2, and an orthographic projection of the second boundary J2 on the substrate 100 is on a side of an orthographic projection of the first touch wiring on the substrate facing away from the display region A. As shown in FIG. 1, the orthographic projection of the second boundary J2 on the substrate is in the first transition region B21. However, in the actual process, since there is a certain instability in the process, there is a certain possibility that the metal residue generated at the second boundary J2 may connect with the second touch metal layer 1112 in the display region, causing a short circuit.

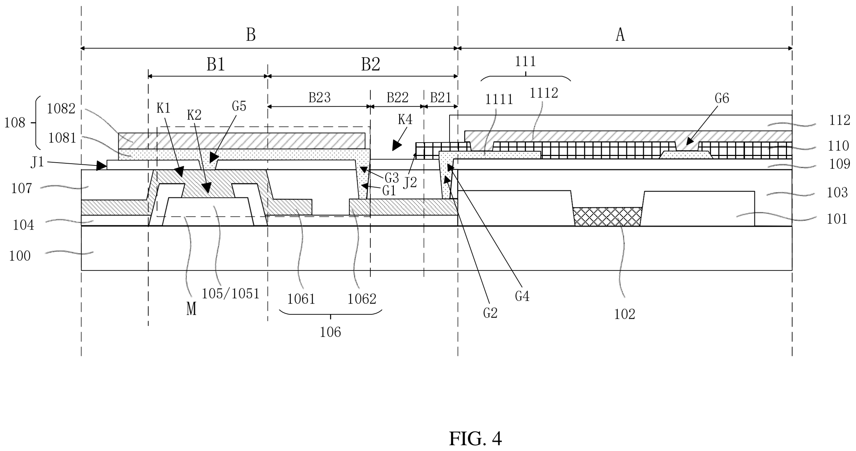

In order to further solve the problem, exemplarily, referring to FIG. 4, the orthographic projection of the second boundary J2 of the second organic insulating layer on the substrate is in the bending region B22. In the embodiment, the second boundary J2 of the second organic insulating layer has a greater distance from the display region, thereby avoiding the problem of a short circuit due to the connection with the second touch metal layer 1112 in the display region caused by the metal residue formed at the boundary, and improving the product yield. Exemplarily, a distance from the second boundary J2 of the second organic insulating layer 110 to the display region A is greater than or equal to 1600 µm.

Exemplarily, as shown in FIGS. 4 to 7, the first organic insulating layer 109 is provided with a first boundary J1. The first boundary J1 is a boundary of the first organic insulating layer 109 facing away from the display region A. A spacing distance between the orthographic projection of the first boundary J1 on the substrate and an orthographic projection of the first opening K1 on the substrate is greater than or equal to 50 µm.

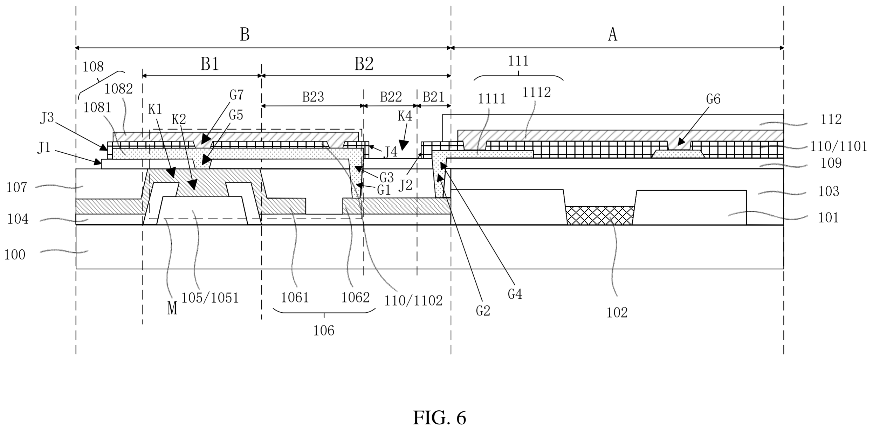

Exemplarily, as shown in FIGS. 6 to 7, the first boundary J1 is on a side of the bonding region B1 facing away from the display region A, and the orthographic projection of the first boundary J1 on the substrate is on a side of the orthographic projection of the first metal structure 1081 on the substrate facing away from the display region A. By setting the spacing distance between the orthographic projection of the first boundary J1 on the substrate and the orthographic projection of the first opening K1 on the substrate to be greater than or equal to 50 µm, the spacing distance between the first organic insulating layer 109 and the metal structure 108 can be ensured during the fabrication of the metal structure 108, avoiding the problem of a short-circuit due to the connecting of the metal structures caused by the metal residue formed at the first boundary J1, and improving the product yield.

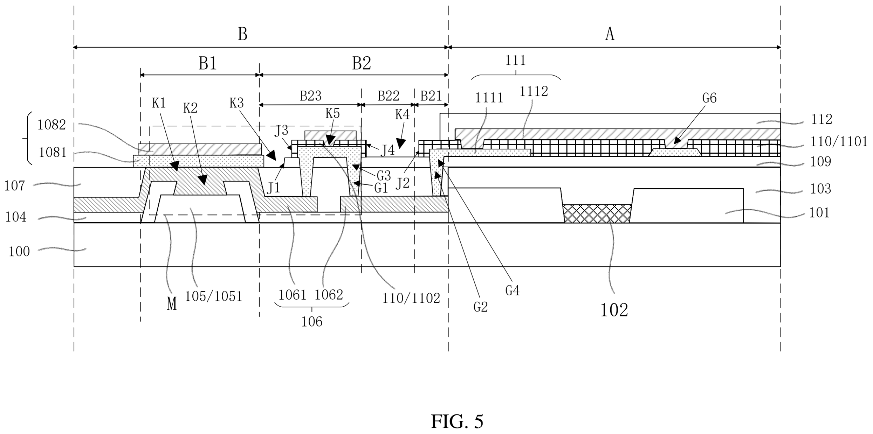

In some other embodiments of the present disclosure, as shown in FIG. 5, the orthographic projection of the first boundary J1 of the first organic insulating layer 109 on the substrate does not overlap with either the orthographic projection of the first metal structure 1081 on the substrate or an orthographic projection of the second metal structure 1082 on the substrate. The second organic insulating layer 110 includes a first organic insulating sub-portion 1101 in the display region A and at least partially extending into the transition region B2. The first organic insulating sub-portion 1101 is on a side of the first organic insulating layer 109 facing away from the substrate 100 and is provided with a sixth via hole G6 in the display region, and the second touch metal layer 1112 is electrically connected with the first touch metal layer 1111 through the sixth via hole G6. Further, the second organic insulating layer 110 is provided with a second organic insulating sub-portion 1102 at least partially located in the second transition region B23 and a fourth opening K4 located between the first organic insulating sub-portion 1101 and the second organic insulating sub-portion 1102, and an orthographic projection of the fourth opening K4 on the substrate 100 at least partially overlaps with the bending region B22. That is, there is no second organic insulating layer 110 in at least a portion of the bending region B22, which reduces the thickness of the film layer in the bending region B22, reduces the bending stress to which the film layer is subjected when bending occurs in the bending region B22, and improves the product yield.

Exemplarily, with continued reference to FIG. 5, the first metal structure 1081 is provided in the bonding region B1 and the second transition region B23, and the first metal structure 1081 is provided with a third opening K3 in the second transition region B23, and the orthographic projection of the first boundary J1 on the substrate is within an orthographic projection of the third opening K3 on the substrate. That is, a first gap is between the first boundary J1 and the bonding region B1. On a side of the third opening K3 facing the display region A, the first metal structure 1081, the second organic insulating sub-portion 1102, and the second metal structure 1082 are sequentially stacked in a direction perpendicular to the substrate. The second organic insulating sub-portion 1102 is also provided with a fifth opening K5 located in the second transition region B23. The first metal structure 1081 is electrically connected with the second metal structure 1082 through the fifth opening K5. The second organic insulating sub-portion 1102 is provided with a third boundary J3 and a fourth boundary J4, where an orthographic projection of the third boundary J3 on the substrate 100 is on a side of an orthographic projection of the fourth boundary J4 on the substrate facing away from the display region A. The orthographic projections of the third boundary J3 and the fourth boundary J4 on the substrate are between the orthographic projection of the first gap on the substrate and the orthographic projection of the fourth opening K4 on the substrate, and the orthographic projection of the third boundary J3 on the substrate is located on a side of the orthographic projection of the first boundary J1 on the substrate 100 facing the display region A.

In the embodiment, as shown in FIG. 10, FIG. 10 illustrates a top view of some structures corresponding to a region where the dotted box M is located in FIG. 5. By making the first metal structure 1081 with the third opening K3, which also means that a disconnection region exists in the first metal structure 1081 at the second transition region B23, and by making the orthographic projection of the third boundary J3 of the second organic insulating sub-portion 1102 on the substrate be located between the orthographic projection of the first gap on the substrate and the orthographic projection of the fourth opening K4 on the substrate, the boundary of the second organic insulating sub-portion 1102 can have a certain distance with the first metal structure 1081 and the second metal structure 1082 in the bonding region B1 and the second transition region B23. By this arrangement, on the basis of ensuring electrical connection, even if the metal residue is generated at the boundary of the organic insulating layer, it will not cause the electrical connection between the metal structures 108 that are adjacent to each other, which can avoid the problem of the short circuit due to the metal residue, and improve the product yield. In addition, by designing two via holes for through connection in the second transition region B23, inter-wire interference between other wirings (not shown in the drawings) located in the second transition region B23 and the bonding portion 1051/1061 can be avoided on the basis of guaranteeing the electrical connection and the isolating effect, so as to guarantee the product performance.

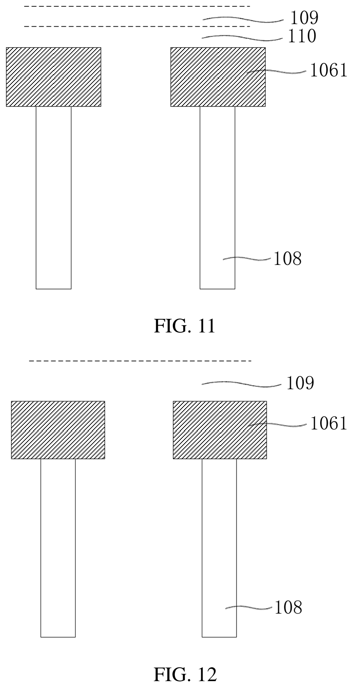

Exemplarily, as shown in FIGS. 6 and 11, the first boundary J1 is on a side of the bonding region B1 facing away from the display region A, and the orthographic projection of the first boundary J1 on the substrate is on a side of the orthographic projection of the first metal structure 1081 on the substrate facing away from the display region A. The first organic insulating layer 109 is provided with a fifth via hole G5 corresponding to the first opening K1, and the first metal structure 1081 is electrically connected with the bonding portion 1051/1061 through the first opening K1 and the fifth via hole G5. The second organic insulating layer 110 is provided with a second organic insulating sub-portion 1102 at least partially located in the second transition region B23 and a fourth opening K4 located between the first organic insulating sub-portion 1101 and the second organic insulating sub-portion 1102. An orthographic projection of the fourth opening K4 on the substrate at least partially overlaps with the bending region B22. The second organic insulating sub-portion includes a fifth opening K5 in the second transition region B23 and a seventh via hole G7 in the bonding region B1. The first metal structure 1081 is electrically connected with the second metal structure 1082 through the fifth opening and the seventh via hole. The second organic insulating sub-portion 1102 is provided with a third boundary J3 and a fourth boundary J4. An orthographic projection of the third boundary J3 on the substrate is on a side of an orthographic projection of the fourth boundary J4 on the substrate facing away from the display region A, and the orthographic projection of the third boundary J3 on the substrate is located on a side of the bonding region B1 facing away from the display region A. By causing the boundary of the organic insulating layer to be located outside of the bonding region, the metal structure can be etched with a certain protective effect when etching the metal structure, so as to avoid side etching.

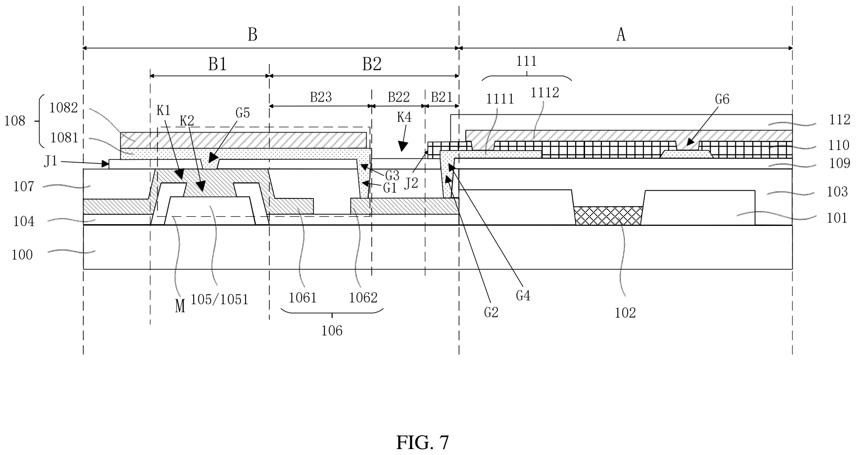

Exemplarily, the orthographic projection of the third boundary J3 on the substrate is located on the side of the orthographic projection of the first boundary J1 on the substrate facing away from the display region A. By this arrangement, a certain distance can be made to exist between the metal structure and the boundary of the organic insulating layer, so that even if a metal residue is generated at the boundary of the organic insulating layer, the problem of a short circuit due to a connection with the metal structure caused by the metal residue can be avoided. Moreover, since the orthographic projection of the third boundary J3 on the substrate is on the side of the orthographic projection of the first boundary J1 on the substrate facing away from the display region A, i.e., the second organic insulating layer 110 is provided to cover the first organic insulating layer 109, it is possible to avoid to increase a short-circuit risk due to a connection between the metal residue generated at the third boundary J3 of the second organic insulating layer 110 and the metal residue generated at the first boundary J1 of the first organic insulating layer 109, and further improve the product yield. Further, as shown in FIGS. 7 and 12, the second organic insulating layer 110 located in the second transition region B23 and the bonding region B1 can also be eliminated, and by removing the second organic insulating layer 110 located in the second transition region B23 and the bonding region B1, the first metal structure 1081 is in direct contact with the second metal structure 1082 in the second transition region B23 and the bonding region B1, and there is no step formed by the second organic insulating layer 110, which can avoid the metal residue during the fabrication of the second metal structure 1082.

Exemplarily, the orthographic projection of the fourth boundary J4 of the second organic sub insulating portion 1102 on the substrate is located in the bending region B22. In this embodiment, the fourth boundary J4 of the second organic sub insulating portion 1102 has a greater distance from the metal structure, thereby avoiding the problem of a short circuit due to a connection between the metal structures caused by the metal residue formed at the boundary, and improving the product yield.

Exemplarily, the first organic insulating sub-portion 1101 is provided with a second boundary J2, and an orthographic projection of the second boundary J2 on the substrate 100 is on a side of the fourth opening K4 facing the display region A. Further, the orthographic projection of the second boundary J2 on the substrate is in the bending region B22. In this embodiment, the second boundary J2 of the first organic insulating sub-portion 1101 has a greater distance from the display region, thereby avoiding the problem of a short circuit due to a connection with the second touch metal layer 1112 in the display region caused by the metal residue formed at the boundary, and improving the product yield.

Exemplarily, as shown in FIGS. 3 to 7, the source-drain metal layer includes a first source-drain metal layer 105 and a second source-drain metal layer 106, the bonding portion 1051/1061 includes a first bonding portion 1051 and a second bonding portion 1061. The first source-drain metal layer 105 is provided with the first bonding portion 1051, and the second source-drain metal layer 106 is provided with the second bonding portion 1061 and the connection portion 1062. A passivation layer 104 is at least partially located in the bonding region B1, and the first source-drain metal layer 105, the passivation layer 104, and the second source-drain metal layer 106 are sequentially arranged in a direction facing away from the substrate. The passivation layer 104 is provided with a second opening K2 in the bonding region B1, and the first bonding portion 1051 is electrically connected with the second bonding portion 1061 through the second opening K2.

Exemplarily, the first metal structure 1081 is provided in the same one layer and is made of the same material as the first touch metal layer 1111, and/or the second metal structure 1082 is provided in the same one layer and is made of the same material as the second touch metal layer 1112. In this manner, the film layer of the metal structure and the film layer of the touch metal can be formed by a single patterning process, which reduces the number of patterning processes for the display panel, simplifies the production of the display panel, and saves production costs.

Exemplarily, as shown in FIGS. 1 to 7, the display panel further includes a pixel defining layer 101 provided on the substrate 100 and located in the display region A, and a light-emitting layer 102. The light-emitting layer may include a red light-emitting layer emitting red light, a green light-emitting layer emitting green light, and a blue light-emitting layer emitting blue light. It should be noted that the light-emitting layer emits light in colors that are illustrated herein only exemplary, which is not limited herein, the light-emitting layer may also be used to emit other colors of light, such as yellow light and white light, which will not be repeated herein. The pixel defining layer 101 is provided with the sixth opening K6 to enable the light-emitting layer 102 to be provided within the sixth opening, and the light-emitting layers of different colors can be prevented from mixing by the pixel defining layer 101. Optionally, the material of the pixel defining layer 101 may include a black material to absorb the ambient light incident to the display panel, avoiding the ambient light being reflected and then emitted out to affect the contrast of the display panel during display.

Exemplarily, as shown in FIGS. 1 to 7, the display panel further includes an encapsulation layer 103 on a side of the pixel definition layer 101 and the light-emitting layer 102 facing away from the substrate 100. The encapsulation layer 103 is at least partially located in the display region A, and an orthographic projection of the encapsulation layer on the substrate 100 covers an orthographic projection of the pixel definition layer 101 and the light-emitting layer 102 on the substrate. The encapsulation layer 103 may, for example, be a thin-film encapsulation layer, i.e., a thin-film encapsulation structure in which an inorganic encapsulation layer, an organic encapsulation layer, and an inorganic encapsulation layer are provided in a stack, which will not be described herein.

Exemplarily, the first organic insulating layer 109 is at least partially provided on a side of the encapsulation layer 103 facing away from the substrate.

It should be noted that the person skilled in the art may understand that the display panel may also contain other film layer structures such as an active layer, a gate layer, a source-drain layer, a passivation layer, and the like, and FIGS. 1 to 7 of the present disclosure only illustrate some of the film layer structures in the display panel.

Based on the same inventive concept, the present disclosure also provides a display device including the above-described display panel provided by the embodiments of the present disclosure. Since the principle of problem solving by the display device is similar to the principle of problem solving by the above-described display panel, the implementation of the display device can be seen in the above-described embodiments of the display panel, and the repetition will not be repeated.

In some embodiments, the above-described display device provided by the embodiments of the present disclosure may be: a mobile phone, a tablet computer, a television set, a monitor, a laptop computer, a digital photo frame, a navigator, a smart-watch, a fitness wristband, a personal digital assistant, and any other product or component having a display function. The display device provided by the embodiments of the present disclosure may also include, but is not limited to, components such as: a radio frequency unit, a network module, an audio output unit, an input unit, a sensor, a display unit, a user input unit, an interface unit, a memory, a processor, and a power supply. It is understood by those skilled in the art that the above composition of the display device does not constitute a limitation of the display device, and that the display device may include more or fewer of the above mentioned components, or a combination of certain components, or a different arrangement of components.

It should be noted that the accompanying drawings of the embodiment of the present disclosure have been adjusted to certain dimensions of the individual membrane layers only for the sake of clarity of the illustrations, and the width, thickness and shape of the membrane layers of the various parts of the accompanying drawings are only schematic displays, and are not a limitation on the proportionality between the dimensions of specific membrane layers.

It should be noted that the above are only some specific embodiments of the present disclosure, these specific embodiments can be combined with each other to form other programs, the scope of protection of the present disclosure is not limited thereto, and other embodiments of the present disclosure will easily come to the mind of a person skilled in the art after considering the specification and practicing the invention disclosed herein. The present disclosure is intended to cover any variations, uses, or adaptations of the present disclosure that follow the general principles of the present disclosure and include means of common knowledge or customary skill in the art not disclosed herein.

## Claims

1. A display panel, comprising:
a substrate, comprising a display region and a peripheral region, wherein the peripheral region comprises a bonding region spaced apart from the display region, and a transition region between the bonding region and the display region;
a source-drain metal layer, comprising a bonding portion at least partially located in the bonding region and a connection portion located in the transition region, wherein the bonding portion is electrically connected with the connection portion;
a planarization layer, provided on the substrate and provided with a first opening in the bonding region and a first via hole in the transition region, wherein the first opening exposes the bonding portion and the first via hole exposes the connection portion;
a first organic insulating layer, located in the display region and the peripheral region, provided on a side of the planarization layer facing away from the substrate, and provided with a third via hole corresponding to the first via hole;
a first metal structure, located in the peripheral region and at least partially provided on a side of the first organic insulating layer facing away from the substrate; wherein an orthographic projection of the first metal structure on the substrate at least covers an orthographic projection of the first opening and the first via hole on the substrate, the first metal structure is electrically connected with the connection portion through the first via hole and the third via hole, and the first metal structure is electrically connected with the bonding portion through the first opening; and
a second metal structure, located in the peripheral region and provided on a side of the first metal structure facing away from the substrate; wherein the second metal structure is in direct contact with the first metal structure.

2. The display panel according to claim 1, wherein the transition region comprises a first transition region, a second transition region, and a bending region between the first transition region and the second transition region; wherein
the first transition region is between the bending region and the display region, and the second transition region is between the bending region and the bonding region;
the first via hole and the third via hole are in the second transition region; and
the connection portion is in the first transition region, the bending region, and the second transition region, and is a continuous structure.

3. The display panel according to claim 2, further comprising:
a second organic insulating layer, provided on the side of the first organic insulating layer facing away from the substrate and provided with a sixth via hole in the display region;
a first touch metal layer, provided in the display region and at least partially extending into the transition region, wherein the first touch metal layer is on a side of the second organic insulating layer facing away from the substrate; and
a second touch metal layer, located on a side of the second organic insulating layer facing the substrate, wherein the second touch metal layer is on the side of the first organic insulating layer facing away from the substrate;
wherein the first touch metal layer is electrically connected with the second touch metal layer through the sixth via hole.

4. The display panel according to claim 3, wherein the first touch metal layer comprises a first touch electrode in the display region and a first touch wiring in the transition region;
the planarization layer further comprises a second via hole in the first transition region, wherein the second via hole exposes the connection portion; and
the first organic insulating layer is further provided with a fourth via hole corresponding to the second via hole, and the first touch wiring is electrically connected with the connection portion through the second via hole and the fourth via hole.

5. The display panel according to claim 4, wherein the second organic insulating layer is provided with a second boundary in the transition region; wherein
an orthographic projection of the second boundary on the substrate is on a side of an orthographic projection of the first touch wiring on the substrate facing away from the display region.

6. The display panel according to claim 5, wherein:
the orthographic projection of the second boundary on the substrate is in the bending region.

7. The display panel according to claim 5, wherein a spacing distance from the second boundary to the display region is greater than or equal to 1600 µm.

8. The display panel according to any one of claims 1-7, wherein the first organic insulating layer is provided with a first boundary; wherein
the first boundary is a boundary of the first organic insulating layer facing away from the display region, and a spacing distance between an orthographic projection of the first boundary on the substrate and an orthographic projection of the first opening on the substrate is greater than or equal to 50 µm.

9. The display panel according to claim 8, wherein the first boundary is on a side of the bonding region facing away from the display region, and the orthographic projection of the first boundary on the substrate is on a side of the orthographic projection of the first metal structure on the substrate facing away from the display region; and
the first organic insulating layer is provided with a fifth via hole corresponding to the first opening, and the first metal structure is electrically connected with the bonding portion through the first opening and the fifth via hole.

10. The display panel according to claim 1, wherein the source-drain metal layer comprises a first source-drain metal layer and a second source-drain metal layer, and the bonding portion comprises a first bonding portion and a second bonding portion, wherein the first source-drain metal layer is provided with the first bonding portion, and the second source-drain metal layer is provided with the second bonding portion and the connection portion; and
a passivation layer, at least partially located in the bonding region, wherein the first source-drain metal layer, the passivation layer and the second source-drain metal layer are sequentially arranged in a direction facing away from the substrate; wherein
the passivation layer is provided with a second opening in the bonding region, and the first bonding portion is electrically connected with the second bonding portion through the second opening.

11. The display panel according to claim 3, wherein the first metal structure is provided in the same one layer as the first touch metal layer and is made of the same material as the first touch metal layer, and the second metal structure is provided in the same one layer as the second touch metal layer and is made of the same material as the second touch metal layer.

12. The display panel according to claim 1, further comprising:
a pixel defining layer, provided on a substrate, located in the display region, and provided with a sixth opening;
a light-emitting layer, provided within the sixth opening; and
an encapsulation layer, at least partially located in the display region, wherein an orthographic projection of the encapsulation layer on the substrate covers an orthographic projection of the pixel defining layer and the light-emitting layer on the substrate;
wherein the first organic insulating layer is provided at least partially on a side of the encapsulation layer facing away from the substrate.

13. A display panel, comprising:
a substrate, comprising a display region and a peripheral region surrounding the display region, wherein the peripheral region comprises a bonding region spaced apart from the display region, and a transition region between the bonding region and the display region;
a source-drain metal layer, comprising a bonding portion at least partially located in the bonding region and a connection portion located in the transition region, wherein the bonding portion is electrically connected with the connection portion;
a planarization layer, provided on the substrate and provided with a first opening in the bonding region and a first via hole in the transition region, wherein the first opening exposes the bonding portion and the first via hole exposes the connection portion;
a first organic insulating layer, located in the display region and the peripheral region, provided on a side of the planarization layer facing away from the substrate, and provided with a third via hole corresponding to the first via hole; wherein the first organic insulating layer is provided with a first boundary, and the first boundary is a boundary of the first organic insulating layer facing away from the display region;
a first metal structure, located in the peripheral region and at least partially provided on a side of the first organic insulating layer facing away from the substrate; wherein an orthographic projection of the first metal structure on the substrate at least covers an orthographic projection of the first opening and the first via hole on the substrate, the first metal structure is electrically connected with the connection portion through the first via hole and the third via hole, and the first metal structure is electrically connected with the bonding portion through the first opening; and
a second metal structure, located in the peripheral region and provided on a side of the first metal structure facing away from the substrate;
wherein an orthographic projection of the first boundary on the substrate does not overlap with either the orthographic projection of the first metal structure on the substrate or an orthographic projection of the second metal structure on the substrate.

14. The display panel according to claim 13, further comprising:
a second organic insulating layer, comprising a first organic insulating sub-portion located in the display region and at least partially extending into the transition region, wherein the first organic insulating sub-portion is provided on the side of the first organic insulating layer facing away from the substrate and provided with a sixth via hole in the display region;
a first touch metal layer, provided in the display region and at least partially extending into the transition region, wherein the first touch metal layer is on a side of the second organic insulating layer facing away from the substrate; and
a second touch metal layer, located on a side of the second organic insulating layer facing the substrate, wherein the second touch metal layer is on the side of the first organic insulating layer facing away from the substrate;
wherein the first touch metal layer is electrically connected with the second touch metal layer through the sixth via hole.

15. The display panel according to claim 14, wherein the transition region comprises a first transition region, a second transition region, and a bending region between the first transition region and the second transition region; wherein
the first transition region is between the bending region and the display region;
the second transition region is between the bending region and the bonding region;
the connection portion is in the first transition region, the bending region, and the second transition region, and is a continuous structure.

16. The display panel according to claim 15, wherein the first touch metal layer comprises a first touch electrode in the display region and a first touch wiring in the transition region;
the planarization layer further comprises a second via hole in the first transition region, wherein the second via hole exposes the connection portion; and
the first organic insulating layer is further provided with a fourth via hole corresponding to the second via hole, and the first touch wiring is electrically connected with the connection portion through the second via hole and the fourth via hole.

17. The display panel according to claim 16, wherein the second organic insulating layer is provided with a second organic insulating sub-portion at least partially located in the second transition region, and a fourth opening located between the first organic insulating sub-portion and the second organic insulating sub-portion, wherein an orthographic projection of the fourth opening on the substrate at least partially overlaps with the bending region.

18. The display panel according to claim 17, wherein the first metal structure is provided in the bonding region and the second transition region, and the first metal structure is provided with a third opening in the second transition region;
wherein the orthographic projection of the first boundary on the substrate is within an orthographic projection of the third opening on the substrate, and a first gap is between the first boundary and the bonding region.

19. The display panel according to claim 18, wherein on a side of the third opening facing the display region, the first metal structure, the second organic insulating sub-portion, and the second metal structure are sequentially stacked in a direction perpendicular to the substrate; and
the second organic insulating layer is further provided with a fifth opening in the second transition region, wherein the first metal structure is electrically connected with the second metal structure through the fifth opening.

20. The display panel according to claim 19, wherein the second organic insulating sub-portion is provided with a third boundary and a fourth boundary, wherein an orthographic projection of the third boundary on the substrate is on a side of an orthographic projection of the fourth boundary on the substrate facing away from the display region; and
the orthographic projection of the third boundary on the substrate and the orthographic projection of the fourth boundary on the substrate are between an orthographic projection of the first gap on the substrate and the orthographic projection of the fourth opening on the substrate, and the orthographic projection of the third boundary on the substrate is on a side of the orthographic projection of the first boundary on the substrate facing the display region.

21. The display panel according to claim 16, wherein the first boundary is on a side of the bonding region facing away from the display region.

22. The display panel according to claim 21, wherein the second organic insulating layer is provided with a second organic insulating sub-portion at least partially located in the second transition region, and a fourth opening between the first organic insulating sub-portion and the second organic insulating sub-portion, wherein an orthographic projection of the fourth opening on the substrate at least partially overlaps with the bending region; and
the second organic insulating sub-portion comprises a fifth opening in the second transition region and a seventh via hole in the bonding region, wherein the first metal structure is electrically connected with the second metal structure through the fifth opening and the seventh via hole.

23. The display panel according to claim 17, wherein the second organic insulating sub-portion is provided with a third boundary and a fourth boundary, wherein an orthographic projection of the third boundary on the substrate is on a side of an orthographic projection of the fourth boundary on the substrate facing away from the display region, and the third boundary is on a side of the bonding region facing away from the display region.

24. The display panel according to claim 23, wherein the orthographic projection of the third boundary on the substrate is on a side of the orthographic projection of the first boundary on the substrate facing away from the display region.

25. The display panel according to claim 20 or 23, wherein the orthographic projection of the fourth boundary on the substrate is in the bending region.

26. The display panel according to claim 16, wherein the first organic insulating sub-portion is provided with a second boundary, wherein an orthographic projection of the second boundary on the substrate is on a side of the fourth opening facing the display region.

27. The display panel according to claim 26, wherein the orthographic projection of the second boundary on the substrate is in the bending region.

28. The display panel according to claim 13, wherein a spacing distance between the orthographic projection of the first boundary on the substrate and an orthographic projection of the first opening on the substrate is greater than or equal to 50 µm.

29. The display panel according to claim 13, wherein the first metal structure is provided in the same one layer as the first touch metal layer and is made of the same material as the first touch metal layer, and the second metal structure is provided in the same one layer as the second touch metal layer and is made of the same material as the second touch metal layer.

30. The display panel according to claim 13, wherein the source-drain metal layer comprises a first source-drain metal layer and a second source-drain metal layer, and the bonding portion comprises a first bonding portion and a second bonding portion, wherein the first source-drain metal layer is provided with the first bonding portion, and the second source-drain metal layer is provided with the second bonding portion and the connection portion; and
a passivation layer, at least partially located in the bonding region, wherein the first source-drain metal layer, the passivation layer and the second source-drain metal layer are sequentially arranged in a direction facing away from the substrate; wherein
the passivation layer is provided with a second opening in the bonding region, and the first bonding portion is electrically connected with the second bonding portion through the second opening.

31. The display panel according to claim 13, further comprising:
a pixel defining layer, provided on a substrate, located in the display region, and provided with a sixth opening;
a light-emitting layer, provided within the sixth opening; and
an encapsulation layer, at least partially located in the display region, wherein an orthographic projection of the encapsulation layer on the substrate covers an orthographic projection of the pixel defining layer and the light-emitting layer on the substrate;
wherein the first organic insulating layer is provided at least partially on a side of the encapsulation layer facing away from the substrate.

32. A display device, comprising: the display panel according to any one of claims 1-12 or claims 13-31.
